# EUROPEAN PATENT SPECIFICATION

(11) **EP 3 076 540 B1**
(45) Date of publication and mention of the grant of the patent: **22.04.2020**
(21) Application number: 15189364.1
(22) Date of filing: 12.10.2015
(51) Int. Cl.: H02P 3/16, H02H 3/00, G01R 31/28

(54) **SYSTEM AND METHOD FOR THE AUTOMATIC VALIDATION OF MOTOR CONTROL FIRMWARE OF AN EMBEDDED SYSTEM**
SYSTEM UND VERFAHREN ZUR AUTOMATISCHEN BEWERTUNG EINER MOTORREGELUNGSFIRMWARE EINES EINGEBETTETEN SYSTEMS
SYSTÈME ET PROCÉDÉ POUR LA VALIDATION AUTOMATIQUE DE MICROLOGICIEL DE COMMANDE D'UN MOTEUR D'UN SYSTÈME INTÉGRÉ

(30) Priority: 30.03.2015 IN 1633CH2015
(43) Date of publication of application: 05.10.2016
(73) Proprietor: Tata Elxsi Limited, Bangalore 560048 (IN)
(72) Inventor: KHAN, Jihas, 690519 Kerala (IN)
(74) Representative: Finnegan Europe LLP

(56) References cited:
- US-B1- 8 108 191
- Opal Rt: "Electric Motor Controller Virtual Test Bench Real-Time Simulation Software, Hardware", , 18 January 2012 (2012-01-18), XP055303365, Retrieved from the Internet: URL:http://www.opal-rt.com/sites/default/f iles/doc/Electric Motor Controller Virtual Test Bench Manual.pdf [retrieved on 2016-09-16]
- SCHULZE T ET AL: "Hybrid drivetrain simulation for hardware-in-the-loop applications", SAE TECHNICAL PAPER SERIES, SOCIETY OF AUTOMOTIVE ENGINEERS, WARRENDALE, PA, US, 1 January 2011 (2011-01-01), page 11pp, XP009156746, ISSN: 0148-7191, DOI: 10.4271/2011-01-0455

## Description

The present invention relates to a system and method for automatic validation of motor control firmware in an embedded system. More particularly, the invention helps in automatically validating a plurality of motor controls in a test bench.

### BACKGROUND

Modern day motors used in various applications are strategically controlled by an embedded system using firmware stored in the embedded system. Specifically, the embedded system uses a combination of different real time input signals to configure a motor to provide desired functionality. For example, the embedded system may use real time input signals such as switch inputs, current drawn by the motor, voltage variations, and motor position feedback information to achieve the desired functionality.

In addition to these functional requirements, the embedded system may also execute a plurality of safety related features. By way of example, the embedded system may be configured to stop certain motors before these motors reach a mechanical end. Typically, the position before the mechanical end at which the motor is stopped is usually called a first stop or a soft stop. The embedded system employs a current motor position that is decoded from position sensors or a sensor-less positioning system for identifying the soft stop. Identifying the soft stop aids in preventing unwanted current shoot-ups (i.e. rapid increases in current) in the motor control lines.

In certain scenarios, if the motor is made to move in the same direction beyond the soft stop, the embedded system is configured to stop the motor at the mechanical end. The motor position corresponding to the mechanical end is called a hard stop or a second stop. Typically, the embedded system relies on the current motor position and electrical current in motor control lines for identifying the hard stop. If this mechanical end is detected during a usual or expected travel limit of the motor that lies between the soft stops of the motor movement in either direction, it is considered as a stall, and the motor is stopped to avoid over-heating. Typically, the embedded system may rely on the current motor position and a current shoot up graph for identifying a stall.

Furthermore, if some obstacle (for example a hand of a user) is trapped in between the moving motor or one or more of its loads, the embedded system is configured to detect a pinch and cause the motor to retract back in opposite direction. This feature is called anti-pinch.

Additionally, the embedded system and its firmware may detect electric current levels beyond designated thresholds during normal or expected movement of the motor. This is called overload detection. Upon detecting an overload, the embedded system may execute specific actions and/or set suitable fault codes. For example, a first set of actions and/or fault codes may be executed upon detecting a mechanical obstacle, whereas a second set of actions and/or fault codes may be executed upon detecting a human body part. Different sets of actions and/or fault codes are executed in these scenarios because a mechanical obstacle may result in a far greater current shoot up as compared to a human body part.

Moreover, embedded systems, such as a seat Electronic Control Unit (ECU) used in an automobile, may employ a calibration routine for optimizing operations. The calibration routine may be executed through automotive protocols like a Controller Area Network (CAN) or a Local Interconnect Network (LIN). Specifically, the calibration routine automatically moves motors continuously. Furthermore, the calibration routine causes storage of the hard end positions in either direction of movement in a non-volatile memory of the ECU based on a detected current shoot-up. This calibration routine may be executed just once by the manufacturer, or may be executed by a service engineer if calibration is lost.

Certain embedded systems control multiple motors, which are connected to an embedded system at the same time, based on a set of functional requirements. A memory recall feature used by an automobile seat ECU is an example. Here, the seat ECU moves multiple motors connected to the seat to allow for simultaneous movement of the seat along different axes to reposition the seat from a current position to a pre-saved position when the passenger presses a memory recall button. The pre-saved positions may be stored in the non-volatile memory of the ECU for implementing the memory-recall feature.

Accordingly, the embedded systems may rely on the current motor position for the implementation of these control algorithms. Typically, the current motor position may be calculated based on the sensor waveforms emanating from the motors. Alternatively, the current motor position may be determined using a sensor-less positioning system in which the embedded system identifies the current motor position based on a back electromotive force (EMF) sensed on the motor control lines. Additionally, an embedded system may store the expected travel ranges of each motor in its non-volatile memory. The stored travel ranges may be used as a reference for checking the soft stop, hard end, stall, and anti-pinch.

Generally, one or more desired functions and safety features of a motor may be independently validated by different verification or validation systems to ensure proper operation of the motor. However, existing verification and validation systems may be used only for a particular situation. Furthermore, the most of these existing systems focus on verification of the physical or hardware parts of the motor, and not the manner in which the motor control firmware works.

EP1775829, for example, relates to a servo motor controller that controls a servo motor for rotationally driving a joint portion of a multi-joint type industrial robot. The servo motor controller further includes a motor control section electrically interconnected to the servo motor via a servo amplifier, and a braking circuit controlled by the motor control section for ON/OFF switching of an electromagnetic brake. The servo motor controller also includes an encoder as a position detector for detecting the position information of the motor. EP1775829, however, only relates to servo motors, and the corresponding servo motor controller appears to have not been designed for the purpose of real time motor control algorithm validation. Particularly, EP1775829 relates to the design of a servo motor controller where interconnection details of motor, brake, and encoder are not considered.

Further, EP1710549 is drawn to a method of testing brakes of a motor of a robot. The motor includes a brake mounted on a shaft of the motor. The position of the shaft is detected by a position encoder. Comparison of the torques at different positions of the shaft may be used for testing the brakes. EP1710549, however, does not address verifying motor control algorithms.

Another method described in US5218860 relates to testing torque characteristics of an electric motor. The method includes the steps of attaching a shaft of an electric motor to a known inertial load, supplying power to the motor at a specified time, measuring the amount of rotation of the motor shaft within known time intervals, calculating the motor's torque by reference to the inertial load and the amount of motor shaft rotation within each of the time intervals, and displaying the motor's torque with reference to the speed of the motor shaft. Here, an inertial load in the form of flywheel is attached to motor shaft for creating a loading effect. However, no automated braking option is provided in this method.

Further, US5404108 proposes a testing apparatus for rotors of electric motors. The apparatus includes a test fixture, which in turn, includes a fixture shaft on which a rotor is temporarily attached to a known inertial load. A stator creates a rotating magnetic field to cause rotation of the rotor, and an encoder senses the amount of angular rotation of the rotor in short time intervals, which is recorded in a memory and later used to calculate torque. Here, a constant inertial load is given to the motor, with no option for automation or variation of load. The documents Opal Rt: "Electric Motor Controller Virtual Test Bench Real-Time Simulation Software, Hardware", as well as US 8 108 191 B1 and SCHULZE T ET AL: "Hybrid drive train simulation for hardware-in-the-loop applications "also disclose simulation test benches but fails to disclose that the motor is without load, the usage of an electromagnetic brake for braking the motor, an optical encoder for detecting the position of the motor and a real time embedded simulator.

### SUMMARY

Disclosed herein is a system and method for automated verification and validation of motor control firmware of an embedded system. According to an embodiment, the system includes a motor without load, where the motor includes an extended shaft. The system also includes an electromagnetic brake for stopping the motor and an optical encoder for detecting the position of the motor, where a shaft emanating from the electromagnetic brake is connected to a shaft of the optical encoder. The system further includes a real time embedded simulator for simulating and receiving real time signals.

The system may include a first coupler for connecting an electromagnetic brake shaft to the extended shaft of the motor. The system may also include a second coupler for connecting the optical encoder shaft to the shaft emanating from the electromagnetic brake.

The real time embedded simulator may include a processor card operating in transistor-transistor logic (TTL) voltage levels and an input/output (I/O) card to handle a plurality of signals including a digital signal, an analog signal, and a pulse width modulation (PWM) signal. The real time embedded simulator may further include a signal-conditioning card to translate TTL voltage level to real world values and vice versa. The electromagnetic brake may be controlled by an analog output pin of the I/O card based on the input from the processor card. The current position of the motor may be calculated using optical encoder pulses by the real time embedded simulator. The system may further include a time control block to control the duration of braking.

Also disclosed herein is a method for automated verification and validation of a motor control firmware of an embedded system as disclosed in the claim 1.

Embodiments of mechanical systems and methods described herein allow for the proper and early validation of motor control algorithms in a closed loop environment by simulating real world conditions in their entirety. Particularly, use of the present systems and methods allows developers to validate and verify control algorithms early in the design cycle, which improves control specification quality and reduces the overall cost and time taken for embedded product design.

### BRIEF DESCRIPTION OF THE DRAWINGS

FIG. 1 illustrates an exemplary instrumentation fixture that forms a part of a test bench and is used for the validation of motor control firmware of an embedded system.
FIG. 2 illustrates an architecture of an embodiment of a system for verification and validation of motor control firmware.
FIG. 3 illustrates exemplary outputs of channel A and channel B of an optical encoder in case of clockwise motion of a motor shaft.
FIG. 4 illustrates exemplary outputs of channel A and channel B of an optical encoder in case of anti-clockwise motion of a motor shaft.
FIG. 5 illustrates a flow chart of an embodiment of a method for verification and validation of motor control firmware.

### DETAILED DESCRIPTION

Reference will now be made in detail to the description of the present subject matter, one or more examples of which are shown in figures. Each example is provided to explain the subject matter, and should not be construed as a limitation. Various changes and modifications obvious to one skilled in the art to which the invention pertains are deemed to be within the scope of the claims.

As used herein, the term "Usual Travel Limit" may be used to refer to the travel of a motor between a designated soft stop in either direction or axis.

The following description presents exemplary systems and methods for testing of a motor control firmware of an embedded system used for controlling motors. To put this another way, the embedded system comprises motor control firmware and the present disclosure is directed to automatically testing that firmware. Particularly, embodiments described herein disclose a system and method for automated verification and validation of motor control firmware of an embedded system in a closed loop environment by simulating real world conditions in their entirety, thereby enhancing control specification quality, and reducing an overall cost and time taken for embedded product design.

Although the embodiments presented herein describe only a few verification and validation methods corresponding to safe operation of a motor, it may be appreciated that embodiments of the present systems and methods may similarly be used to verify and validate other functions and/or features of an embedded system. Certain embodiments of the present systems and methods will be described in greater detail in the following sections with reference to the figures.

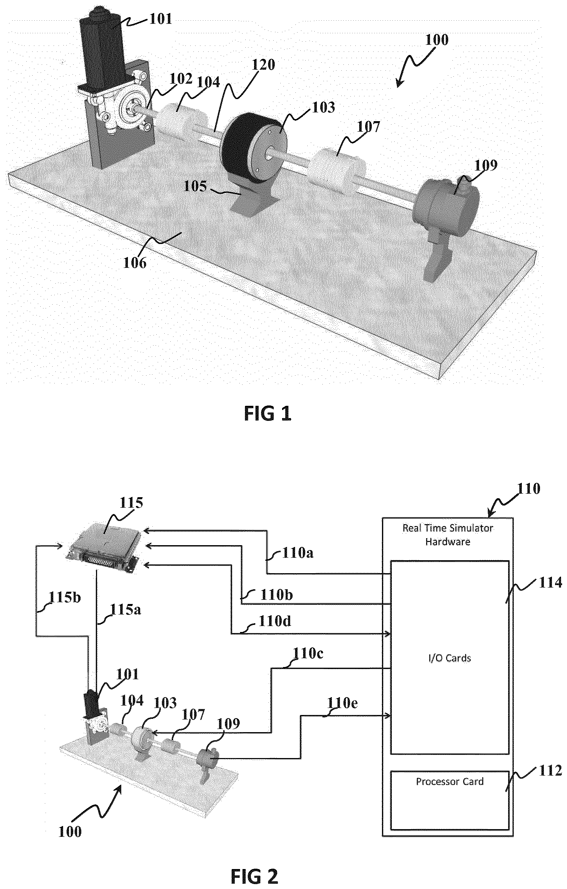

FIG. 1 illustrates an instrumentation fixture 100, which may be part of a test bench system used for the verification and validation of motor control firmware of an embedded system. The system includes a motor 101 without load. The motor 101 includes a shaft 102. In one embodiment, the shaft 102 is an extended shaft. The system also includes an electromagnetic brake 103 for stopping the motor 101. The electromagnetic brake 103 is attached to the extended shaft 102. In certain embodiments, a bore size (diameter) of the electromagnetic brake 103 and a size (diameter) of the extended shaft 102 may be different. Accordingly, the system may include a first coupler 104 for compensating for a difference in the size of the extended shaft 102 and the electromagnetic brake 103. The first coupler 104, for example, may be metallic.

Further, in one embodiment, the electromagnetic brake 103 may be a DC electromagnetic brake. Additionally, in certain embodiments, the electromagnetic brake 103 may include a moving part 120 and a static part. The moving part 120 may comprise a shaft. The static part is strongly fixed to a base frame 106 by a metal leg 105. The base frame 106, for example, may be made of aluminum and the leg 105 may be a metal leg. The moving part 120 is connected to the extended shaft 102, for example, via the first coupler 104.

During operation, rotation of the motor 101 causes the moving part 120 of the electromagnetic brake 103 to rotate. For safe motor operation, the stopping torque of the electromagnetic brake 103 should generally be greater than a maximum torque of the motor 101. In one embodiment, the static part of the electromagnetic brake 103 is an electromagnet. When a direct current (DC) supply is given to the electromagnet, the electromagnet is magnetized to result in attraction of the moving part 120 towards the static part, thereby preventing further motion of the moving part 120. A stopping torque of the electromagnet may be reduced proportionally by applying the DC supply, which is less than its rated supply voltage. The maximum stopping torque occurs when a rated supply voltage is applied to the brake.

In certain embodiments, the system may also include an optical encoder 109 for detecting a current position of the motor 101. The shaft (e.g. moving part 120) emanating from the electromagnetic brake 103 is connected to a shaft of the optical encoder 109. The optical encoder 109 may convert the mechanical motion of the extended shaft 102 of the motor 101 to corresponding electrical pulses. The direction of rotation and the position of the extended shaft 102 are determined from the electrical pulses of the optical encoder 109. A second coupler 107 may be employed between the shaft emanating from the electromagnetic brake 103 and the optical encoder shaft to reconcile size (diameter) mismatches between the shafts of the electromagnetic brake 103 and the optical encoder 109. The second coupler 107, thus, may connect the shaft emanating from the electromagnetic brake 103 to the optical encoder shaft.

In one embodiment, certain components depicted in FIG. 1 including the motor 101, electromagnetic brake 103, and the optical encoder 109 may be fixed to an aluminum frame 106. The entire arrangement of components that are fitted to the aluminum frame 106 may together be referred to herein as the instrumentation fixture. More than one motor often needs to be controlled by the embedded system simultaneously. Accordingly, more than one such assembly of one or more motors, electromagnetic brakes, and optical encoders may be fixed to the same fixture of the test bench system for validation of simultaneous motor control requirements.

Further, FIG. 2 illustrates an exemplary architecture of the system of FIG. 1, in accordance with an embodiment. Referring to FIG. 2, the system includes the test fixture 100 and a real time embedded simulator 110 for simulating and receiving real time signals. The real time embedded simulator 110 is herein after referred to as the embedded simulator 110. In one embodiment, the test fixture 100 and embedded simulator 110 are electronically connected to the embedded system 115. The embedded system 115 is the system whose firmware is to be validated and verified by the test fixture 100 and the embedded simulator 110.

To that end, in one embodiment, the embedded simulator 110 includes a processor card 112 operating in digital voltage levels, such as transistor-transistor logic (TTL) voltage levels. The embedded simulator 110 also includes an input/output (I/O) card 114 to handle a plurality of signals including a digital signal, an analog signal, and a pulse width modulation (PWM) signal. In this embodiment, the embedded simulator 110 also includes a signal-conditioning card to translate TTL voltage levels to real world values, and vice versa.

For example, the signal conditioning card includes one or more digital to analog converters and one or more analog to digital converters for converting digital values to corresponding "real world" analog voltages, and vice versa. The processor card 112 has the logic for the whole test assembly, which controls relevant pins of the I/O Card 114. In one embodiment, the I/O card 114 of the embedded simulator 110 may provide a button press simulation 110a and a protocol simulation 110b to the embedded system. The I/O card 114 of the embedded simulator 110 may also provide a brake control signal 110c to the electromagnetic brake 103. Additionally, the embedded simulator 110 may receive an input from a debug port interface 110d of the embedded system and may receive optical encoder pulses 110e from the optical encoder 109. Further, the embedded system 115 may provide a motor control signal 115a directly to the motor 101 and may receive a motor sensor feedback signal 115b.

The embedded system 115 is configured to drive the motor 101 directly. The motor control firmware in the embedded system 115 may be configured to sense a current motor position using the sensor feedback signal 115b from the motor itself. In the case of modern motor controllers, sensor-less positioning may be employed, which makes use of back EMF for sensing the current motor position. Instead of the sensor pulses from the motor 101, the present disclosure makes use of more accurate high duty optical encoder pulses. This is accomplished by wiring the output of optical encoder 109, which is a digital pulse, to digital input pins in the I/O card 114. The electromagnetic brake 103 may be controlled by a high current analog output pin of the I/O card 114. Additionally, the present architecture allows for a high-speed bidirectional internal communication between the processor card 112 and the I/O card 114 of the embedded simulator 110. In certain embodiments, the processor card 112 may also be capable of calculating the current motor position based on received optical encoder pulses. Use of an embodiment of the present architecture, thus, allows the processor card 112 to apply the electromagnetic brake 103 at its discretion.

According to certain aspects of the present disclosure, the system uses an optical encoder 109 to translate the mechanical rotation of the extended shaft 102 into electrical pulses. The optical encoder 109 also helps in position detection of a motor 101 equipped with sensor-less positioning functionality. Use of the optical encoder is a cost effective solution as decoding the position using sensor-less positioning (which makes use of back EMF) requires complex circuitry and time-consuming computations. Since the system is not relying on a hall sensor inside the motor 101 or the back EMF of the motor 101, it can also identify irregularities in the motor 101 and a sensor used in the motor 101. Accordingly, in one exemplary implementation, a standard rugged optical encoder 109 with a very high pulse per revolution (e.g. 1024 PPR) may be used in the test bench. In this implementation, the optical encoder 109 may have two outputs, which may be referred to as Channel A and Channel B.

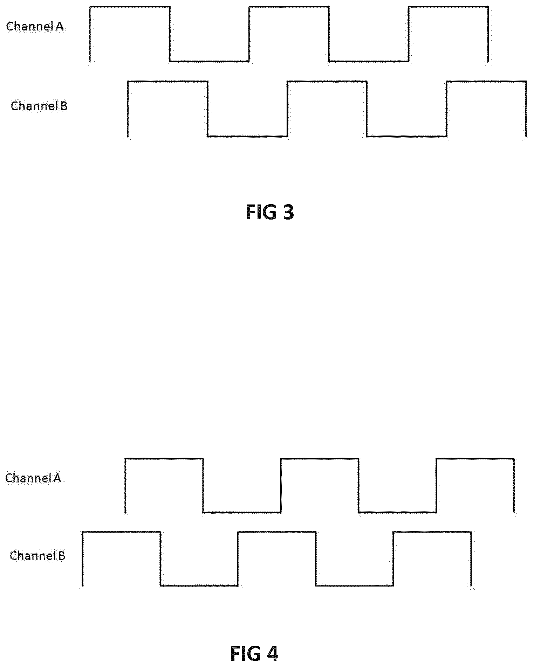

FIG. 3 and 4 illustrate the output of Channel A and Channel B of the optical encoder 109 in the case of clockwise motion and anti-clockwise motion of the motor shaft 102, respectively. Specifically, the optical encoder 109 includes two digital output lines representative of electrical pulses whose rising edges show a change in the position of the motor shaft 102. For example, FIG. 3 depicts the output of the optical encoder 109 in the case of clockwise motion. Particularly, in FIG. 3, it is seen that Channel B leads Channel A by 90° while a duty cycle of both the waveforms remains the same.

Further, FIG. 4 depicts the output of the optical encoder 109 in case of anti-clockwise motion of the motor shaft 102. Particularly, in FIG.4, it can be seen that Channel A leads Channel B by 90° while the duty cycle of both the waveforms remains the same. Specifically, the rising edges of both the waveforms indicate the change in motor position, while the phase difference shows the direction of travel. In the embodiment depicted in FIG. 4, Channel A and Channel B are wired to a digital input of the embedded simulator 110. Accordingly, the embedded simulator 110 detects a motor position from optical encoder pulses.

In certain embodiments, the embedded simulator 110 may represent the motor position (e.g. the angular displacement of the shaft 102) by means of a "motor position count," which is derived from optical encoder pulses in the following manner. The embedded simulator 110 increments the motor position count when there is rising edge in Channel A and a high value in Channel B of the optical encoder pulse. Similarly, the embedded simulator 110 decrements the motor position count when there is rising edge in Channel B and a high value in Channel A. The current position of the motor 102, thus determined by the embedded simulator 110, may be used in the validation methods described in the following sections.

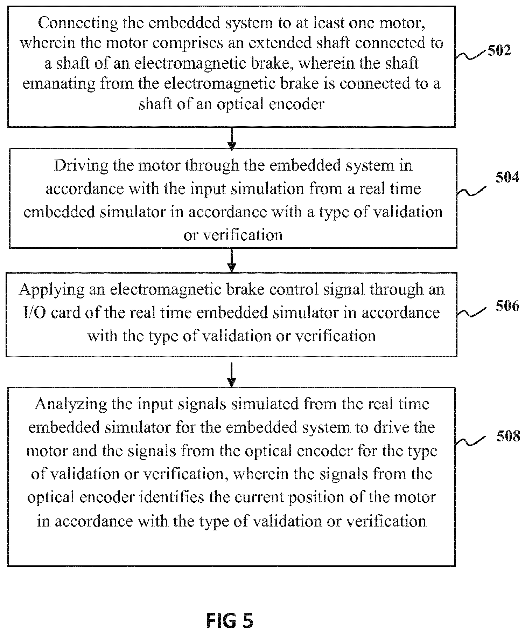

FIG. 5 illustrates a flow chart of an embodiment of a method for automated verification and validation of a motor control firmware of an embedded system. The method optionally includes a step 502 of connecting the embedded system 115 to drive a motor 101, where the motor 101 includes a shaft 102 connected to an electromagnetic brake 103. The shaft emanating from the electromagnetic brake 103, in turn, is connected to a shaft of an optical encoder 109. Alternatively, the embedded system 115 could already be connected to the motor 101, such that the method starts with the following step 504.

At step 504, the motor 101 is driven through the embedded system in accordance with an input simulation received from an embedded simulator 110. The input simulation is configured to perform a desired type of validation or verification of the motor control firmware. The type of validation or verification may be a particular test, such as anti-pinch validation or verification of soft stop functionality, as discussed below. The method further includes a step 506 of applying an electromagnetic brake control signal through an I/O card 114 of the embedded simulator 110 in accordance with the type of validation or verification. Additionally, the method includes a step 508 of performing the verification or validation by analyzing the input signals simulated by the embedded simulator 110 for the embedded system to drive the motor 101 and the signals from the optical encoder 109 for the type of validation or verification. Here, the signals from the optical encoder 109 identify the current position of the motor 101 in accordance with the type of verification or validation.

In one embodiment, the method of validation or verification includes anti-pinch validation. The step of applying the electromagnetic brake control signal is performed in such a way that the electromagnetic brake 103 applies a maximum force for short duration while the motor 101 is moving in its usual travel limit. In this context, a "short" duration is preferably understood to mean that the brake 103 is applied for a determined period of time that is less than a period of time required to stop the motor 101 permanently, or to stop the motor 101 at all. The brake control signal 110c emanating from the embedded simulator 110 may be provided to a timing control block, which controls the duration for which the brake 103 is to be applied, where the brake control signal 110c is derived from the analog output of embedded simulator 110.

Generally, a human body part obstacle and a real mechanical obstacle may cause different amounts of current shoot up for a motor. Anti-pinch validation makes use of brake applied for a relatively short duration so as to simulate the effect of a human body part obstacle. Once the brake is applied, after 'n' milliseconds, if the motor is made to rotate in the opposite direction by the embedded system as compared to its previous motion, anti-pinch validation is determined to be 'PASSED'. The step of analyzing verifies whether the motor position decoded from the optical encoder pulses is increasing if the motor position was previously decreasing or decreasing if the motor position was previously increasing, which indicates that the motor has been made to rotate in the opposite direction. The test system is also capable of validating the amount by which the motor retracted and the time it took for the same by utilizing change of motor position value and a timer.

In another embodiment, the method of validation or verification includes verification of a soft stop feature. The embedded simulator 110 receives the pre-saved soft stop position from the embedded system 115 (for example, by reading through a debug port of the embedded system 115). The soft stop position may be stored (pre-saved) in the embedded simulator 110. In certain embodiments, users may control the embedded system 115 through a switch pack, which is either hardwired or interfaced using specific protocols. Such a switch pack includes one or more switches. An embodiment of the present system for verification and validation may not use a real switch. Therefore, the control signal may be simulated from the embedded simulator hardware. The embedded simulator 110 generates the control signals representative of the switch pack for the embedded system 115 for moving the motor 101 in one direction continuously. The step of analyzing verifies whether the motor 101 is moving in its usual travel limit when stopped by the embedded system and whether the motor 101 is stopped at a position equal to the pre-saved soft stop position. The position is decoded from the optical encoder pulses. In a particular scenario, when the switch simulation is in an "on" position, the motor 101 is in the usual travel limit and the motor 101 is made to stop at the pre-saved soft stop position by the embedded system 115, then the soft stop validation is considered to have 'PASSED.'

According to a further embodiment, the method of validation or verification includes verification of stall detection. For purposes of stall detection, the electromagnetic brake control signal 110c applies the brake 103 for a relatively long duration with full force while the motor 101 is moving in its usual travel limit. The step of analyzing verifies whether the motor position decoded from the optical encoder 109 does not change as soon as the brake 103 is released.

According to yet another embodiment, the method of validation or verification includes verification of hard end detection. The electromagnetic brake control signal 110c applies the brake 103 for a long duration with full force while the motor 101 is moving outside its usual travel limit, where the step of applying the electromagnetic brake control signal entails applying the brake 101 at a previously known hard end position. As used herein, the term "long" duration is preferably understood to mean that the brake 103 is applied for a specified period of time that is sufficient to stop the motor completely or permanently. If this causes the motor 101 to stop completely, hard end detection is said to have 'PASSED'. For the hard end detection, the embedded simulator 110 may receive the previously known hard end position, for example, from the debug port interface 110d of the embedded system 115. Further, the step of analyzing verifies whether the motor position decoded from optical encoder fails to change as soon as the brake 103 is released.

In another embodiment, the method of validation or verification includes verification of the position detection functionality of the embedded system. The step of driving the motor drives the motor for a predetermined time, for example for about 'n' seconds. In a particular implementation, for example, 'n' may represent a minimum of 15 seconds to a maximum 300 seconds. The step of analyzing compares the change in a motor position count obtained by decoding the optical encoder pulses with the change in the motor position count received from the embedded system for 'n' seconds. The change in the motor position count may be output from the debug port of the embedded system and received through the debug port interface 110d of the embedded simulator 110.

For motors that are equipped with position detection sensors, this test solution may also be used for verifying the accuracy of those sensors by comparing the counts from the embedded simulator 110 and from the embedded system 115 (e.g. through debug port interface) for the same travel range or time of operation. For motors that are equipped with sensor-less positioning, the same test solution can be used for verifying the accuracy of sensor-less positioning algorithm by comparing the counts from the embedded simulator 110 and from the embedded system 115 (e.g. through debug port interface) for the same travel range or time of operation.

According to a further embodiment, the method of validation or verification includes verification of overload detection. The overload scenario may be simulated by applying the electromagnetic brake 103 partially while the motor 101 is in motion. In certain embodiments, applying the electromagnetic brake 103 partially increases the load on the motor 101 without stopping the motor 101. The overload condition of the motor is created by reducing the supply voltage input to the electromagnetic brake 103, where the ratio (or percentage) of the applied voltage to the electromagnetic brake 103 with respect to the actual nominal voltage of the electromagnetic brake 103 determines the amount of overload applied. The step of analyzing compares the behavior of the embedded system 115 with the requirement provided and setting of the relevant fault codes. In one embodiment, the embedded simulator 110 may include a lookup table that may be used to calculate the voltage required at the brake supply lines for the required braking torque/load.

Generally, a basic requirement of many motor control systems is to control the motor position, movement, and/or speed to a desired value at the request of button press events. Accordingly, button presses needed by the embedded system 115 may be simulated by the digital/analog output/protocol pins of the embedded simulator 110. Further, a position decoded from the optical encoder 109 pulses may be used to verify that the motor position, speed, and/or movement are correctly controlled by the embedded system 115.

According to an embodiment, the method of validation or verification corresponds to position and speed control of the motor 101 by the embedded system 115. In an exemplary implementation, the motor 101 is driven for 'n' seconds by a switch of the embedded simulator 110 through the embedded system 115. The step of analyzing decodes the optical encoder 109 pulses to determine the motor position so as to verify whether the motor position and movement is correctly controlled by the embedded system 115. Additionally, the step of analyzing further calculates the motor speed in revolutions or rotations per minute (RPM) using the data received from the optical encoder 109. The step of analyzing further compares the motor speed against a speed requested by the embedded system 115. In one embodiment, motor speed in RPM is calculated by taking the ratio of a calculated position increment or decrement in one minute to the pulse per revolution of the optical encoder 109. Motor speed calculated by the test system 110 is compared against the speed requested by the embedded system 115. This is especially helpful to modern day PWM controlled motors, where motors are run at different speeds by varying the PWM duty cycle.

According to another embodiment, the method of validation or verification includes verification of a calibration routine. The step of driving the motor 101 is performed continuously in one direction by the embedded system 115. The brake 103 is applied by the embedded simulator 110 with full force and for a long duration. Following application of the brake 103, the current motor position computed from optical encoder 109 pulses should be equal to the pre-saved expected calibration point. The step of analysis reads the hard end positions stored in the non-volatile memory of the ECU (e.g. through the debug port interface of the embedded system) to analyze the similarity between the read hard end positions with the expected hard end positions. The steps corresponding to the calibration routine may also be repeated whilst driving the motor 101 in the opposite direction.

In certain embodiments, one or more of the motor control firmware testing methods may be implemented to perform testing or verification of individual or any combination of motor control features such as anti-pinch, soft stop, stall detection, hard end detection, position detection, overload detection, position/movement/speed control and calibration. Moreover, these tests or types of verification or validation can be performed in any order.

Furthermore, as previously noted, the present disclosure describes only a few verification and validation methods. However, it may be appreciated that various other verification and/or validation methods may be tested using the test bench fixture 100 disclosed herein. Additionally, the system may be used with more than one assembly of one or more motors, shafts, brakes, and optical encoders. In such a scenario, the embedded simulator may be capable of verifying and/or validating algorithms used for simultaneous control of such a system that includes more than one motor.

Thus, depending upon an intended application of a device and/or area of use, the present system and methods may allow for validation of different motor control algorithms having different functional requirements. Particularly, the adaptive and generalized test bench design disclosed herein allows a test engineer to configure the system for validation and verification of a plurality of requirements. To that end, in one embodiment, the test engineer may be given selected read and write access to embedded system control signals (button presses), the current motor position value, and/or brake control signals for designing and verifying different motor control algorithms. Furthermore, the generalized test bench allows for use of the verification and validation methods in any sequential combination for testing and verifying different real world scenarios.

Moreover, the test bench allows for complete automation of test procedures. To that end, in one embodiment, a test script may be prepared in a spreadsheet format according to desired validation requirements. The validation requirements, for example, may include all input variables such as an embedded system controlling button signal, a brake control signal; and all output variables, such as a current motor position, a motor status, and a direction of motor rotation. Different combinations of input signals and expected output signals may be entered in the test script, which may be sequentially executed. Actual outputs may subsequently be compared against the expected output in the test script to determine whether the test case passes or fails. The test bench is configured to allow for automatic execution of all of these operations without any manual intervention. For example, the test bench may include a graphical user interface that provides the test engineer access to the signals used in test bench control for executing an in depth testing and reviewing test results.

Embodiments of the present systems and methods, thus, provide mechanical systems and methods for early and automated validation of motor control algorithms in a closed loop environment by simulating the real world conditions in their entirety. Use of the mechanical test bench provides a consolidated platform that facilitates automated verification and validation of different kinds of control algorithms early in the design cycle, which aids in improving control specification quality and can reduce overall cost and time for embedded product design. Particularly, the present methods and systems allow for verification and validation of all types of motors within the same test bench fixture with any type of position feedback. The disclosed method and system, thus, enable effective implementation of the embedded system, which in turn, may aid in reducing scenarios for potential product recalls.

Although specific features of various embodiments of the present systems and methods may be shown in and/or described with respect to some drawings and not in others, this is for convenience only. It is to be understood that the described features, structures, and/or characteristics may be combined and/or used interchangeably in any suitable manner in the various embodiments, for example, to construct additional assemblies and techniques for use in automated testing, verification, and validation systems.

## Claims

1. A method for automated verification and validation of a motor control firmware of an embedded system (115), the embedded system being connected to at least one motor (101), wherein the motor comprises a shaft (102) connected to a shaft of an electromagnetic brake (103), wherein the shaft of the electromagnetic brake is connected to a shaft of an optical encoder (109), wherein the method comprises:
driving (504) the motor (101) through the embedded system (115) in accordance with a simulated input signal provided to the embedded system from an embedded simulator (110) for simulating and receiving real time signals, the simulated input signal being configured to perform a particular test for validation or verification of the motor control firmware, wherein the particular test for validation or verification comprises one or more of an anti-pinch validation, a test of soft stop feature, a test of stall detection, a test of hard end detection, a test of position detection, a test of overload detection, a test of position control, and a test of calibration;
applying (506) an electromagnetic brake control signal through the embedded simulator (110) in accordance with the particular test for validation or verification; and
performing the verification or validation by analyzing (508) the simulated input signal from the embedded simulator (110) and signals from the optical encoder (109), wherein the signals from the optical encoder identify the current position of the motor (101);
wherein if the test for validation or verification comprises the anti-pinch validation: the step of applying (506) the electromagnetic brake control signal is with maximum force for a short duration while the motor (101) is moving in its usual travel limit, and the step of analyzing (508) verifies whether a motor position decoded from the optical encoder signals is increasing if the motor position was previously decreasing or decreasing if the motor position was previously increasing;
wherein if the test for validation or verification comprises the test of a soft stop feature: the embedded simulator (110) simulates control signals corresponding to one or more switches, the control signals being provided to the motor control firmware of the embedded system (115) for moving the motor (101) in one direction continuously, and the step of analyzing (508) verifies whether the motor (101) moves in its usual travel limit and is stopped by the embedded system at a position, wherein the position decoded from the optical encoder pulses is equal to a pre-saved soft stop position;
wherein if the test for validation or verification comprises the test of stall detection: the electromagnetic brake control signal causes application of the brake (103) for a long duration with full force while the motor (101) is moving in its usual travel limit, and the step of analyzing (508) verifies whether the motor position decoded from optical encoder (109) does not change as soon as the brakes are released;
wherein if the test for validation or verification comprises the test of hard end detection: the electromagnetic brake control signal causes application of the brake (103) for a long duration with full force while the motor (101) is moving outside its usual travel limit, and the electromagnetic brake control signal causes application of the brake (103) at a predetermined hard end position, and the step of analyzing (508) verifies whether the motor position decoded from optical encoder (109) does not change as soon as the brakes are released;
wherein if the test for validation or verification comprises the test of position detection: the step of driving (504) the motor drives the motor (101) for a predetermined time, and the step of analyzing (508) compares the change in a motor position count obtained by decoding the optical encoder signals with a change in the motor position count received from the embedded system by the embedded simulator (110);
wherein if the test for validation or verification comprises the test of overload detection: the overload condition of the motor (101) is created by applying a reduced supply voltage input to electromagnetic brake (103) while the motor (101) is moving, wherein the ratio of the voltage applied to the brake (103) with respect to the actual nominal voltage of the brake determines an amount of overload applied;
wherein if the test for validation or verification comprises the test of position control: the motor (101) is driven for a predetermined time, and the step of analyzing (508) decodes the optical encoder (109) signal to decode the motor position to verify whether the motor position and movement is correctly controlled by motor control firmware of the embedded system (115), and the step of analyzing (508) further calculates the motor speed using data received from the optical encoder (109) to compare the motor speed against the speed requested by the motor control firmware of the embedded system (115); and
wherein if the test for validation or verification comprises the test of calibration: the step of driving (504) the motor is performed in one direction continuously by the motor control firmware of the embedded system (115), and whereby the brake (103) is applied by the embedded simulator (110) with full force and for a long duration until the motor position decoded from encoder pulses is equal to the expected hard end position, and the step of analyzing (508) is performed by reading the hard end positions stored in the embedded system (115) to analyze the similarity between the read hard end position with the expected hard end position.

2. A system for the automated verification and validation of motor control firmware of an embedded system, the system comprising:
at least one motor (101) without load, wherein the motor (101) comprises a shaft (102);
at least one electromagnetic brake (103) for stopping the motor (101), wherein the electromagnetic brake is attached to the shaft (102) of the motor (101);
at least one optical encoder (109) for detecting the position of the motor (101), wherein a shaft emanating from the electromagnetic brake (103) is connected to a shaft of the optical encoder (109); and
at least one embedded simulator (110) for simulating and receiving real time signals wherein the embedded simulator (110) is configured to perform the method of claim 1.

3. The system as claimed in claim 2, wherein the system is a test bench.

4. The system as claimed in claim 3, wherein the test bench comprises multiple assemblies of the at least one motor (101), at least one electromagnetic brake (103), at least one optical encoder (109), or a combination thereof, fixed to a single fixture (100) of the test bench.

5. The system as claimed in claims 2 to 4, wherein the test bench comprises a user interface that provides a user with one or more of read access and write access to embedded system control signals, a current motor position value, brake control signals, or combinations thereof, for defining different verification or validation requirements for testing.

6. The system as claimed in claims 2 to 5, wherein the embedded simulator comprises:
a processor card (112) operating in digital voltage levels;
an input/output card (114) to handle plurality of signals including a digital signal, an analog signal and a pulse width modulated signal; and
a signal-conditioning card to translate a digital voltage level to an analog value and vice versa;
wherein the electromagnetic brake (103) is controlled by an analog output pin of the input/output card (114) based on the input from the processor card (112).

## Patentansprüche

1. Verfahren zur automatischen Verifikation und Bewertung einer Motorregelungsfirmware eines eingebetteten Systems (115), wobei das eingebettete System mit mindestens einem Motor (101) verbunden ist, wobei der Motor eine Welle (102) umfasst, die mit einer Welle einer Elektromagnetbremse (103) verbunden ist, wobei die Welle der Elektromagnetbremse mit einer Welle eines optischen Codierers (109) verbunden ist, wobei das Verfahren umfasst:
Antreiben (504) des Motors (101) durch das eingebettete System (115) gemäß einem simulierten Eingangssignal, das dem eingebetteten System von einem eingebetteten Simulator (110) zum Simulieren und Empfangen von Echtzeitsignalen bereitgestellt wird, wobei das simulierte Eingangssignal konfiguriert ist, einen jeweiligen Test zur Bewertung oder Verifikation der Motorregelungsfirmware durchzuführen, wobei der jeweilige Test zur Bewertung oder Verifikation eine/eines oder mehrere von einer Einklemmschutzbewertung, einem Soft-Stop-Funktionstest, einem Blockiererkennungstest, einem Hard-End-Erkennungstest, einem Positionserkennungstest, einem Überlasterkennungstest, einem Positionskontrolltest und einem Kalibriertest umfasst;
Anlegen (506) eines Elektromagnetbremsensteuersignals durch den eingebetteten Simulator (110) gemäß dem jeweiligen Test zur Bewertung oder Verifikation; und
Durchführen der Verifikation oder Bewertung durch Analysieren (508) des simulierten Eingangssignals von dem eingebetteten Simulator (110) und von Signalen von dem optischen Codierer (109), wobei die Signale von dem optischen Codierer die aktuelle Position des Motors (101) identifizieren;
wobei, wenn der Test zur Bewertung oder Verifikation die Einklemmschutzbewertung umfasst: der Schritt des Anlegens (506) des Elektromagnetbremsensteuersignals mit maximaler Kraft für kurze Zeit erfolgt, während sich der Motor (101) in seiner üblichen Verfahrgrenze bewegt, und der Schritt des Analysierens (508) verifiziert, ob eine aus den optischen Codierersignalen decodierte Motorposition zunimmt, wenn die Motorposition zuvor abnahm, oder abnimmt, wenn die Motorposition zuvor zunahm;
wobei, wenn der Test zur Bewertung oder Verifikation einen Soft-Stop-Funktionstest umfasst: der eingebettete Simulator (110) Steuersignale entsprechend einem oder mehreren Schaltern simuliert, wobei die Steuersignale an die Motorregelungsfirmware des eingebetteten Systems (115), zum kontinuierlichen Bewegen des Motors (101) in einer Richtung, bereitgestellt werden, und der Schritt des Analysierens (508) verifiziert, ob sich der Motor (101) in seiner üblichen Verfahrgrenze bewegt und von dem eingebetteten System an einer Position angehalten wird, wobei die aus den optischen Codiererimpulsen decodierte Position gleich einer vorgespeicherten Soft-Stop-Position ist;
wobei, wenn der Test zur Bewertung oder Verifikation den Blockiererkennungstest umfasst: das Elektromagnetbremsensteuersignal eine Betätigung der Bremse (103) für lange Zeit mit voller Kraft bewirkt, während sich der Motor (101) in seiner üblichen Verfahrgrenze bewegt, und der Schritt des Analysierens (508) verifiziert, ob die aus dem optischen Codierer (109) decodierte Motorposition sich nicht ändert, sobald die Bremsen gelöst sind;
wobei, wenn der Test zur Bewertung oder Verifikation den Hard-End-Erkennungstest umfasst: das Elektromagnetbremsensteuersignal eine Betätigung der Bremse (103) für lange Zeit mit voller Kraft bewirkt, während sich der Motor (101) außerhalb seiner üblichen Verfahrgrenze bewegt, und das Elektromagnetbremsensteuersignal eine Betätigung der Bremse (103) an einer vorbestimmten Hard-End-Position bewirkt, und der Schritt des Analysierens (508) verifiziert, ob die aus dem optischen Codierer (109) decodierte Motorposition sich nicht ändert, sobald die Bremsen gelöst sind;
wobei, wenn der Test zur Bewertung oder Verifikation den Positionserkennungstest umfasst: der Schritt des Antreibens (504) des Motors den Motor (101) für eine vorbestimmte Zeit antreibt, und der Schritt des Analysierens (508) die Veränderung einer Motorpositionszählung, die durch Decodieren der optischen Codierersignale erhalten wird, mit einer Veränderung der Motorpositionszählung, die aus dem eingebetteten System von dem eingebetteten Simulator (110) empfangen wird, vergleicht;
wobei, wenn der Test zur Bewertung oder Verifikation den Überlasterkennungstest umfasst: der Überlastzustand des Motors (101) durch Anlegen eines reduzierten Versorgungsspannungseingangs an die Elektromagnetbremse (103) entsteht, während sich der Motor (101) bewegt, wobei das Verhältnis der an die Bremse (103) angelegten Spannung zu der tatsächlichen Nennspannung der Bremse einen angelegten Überlastbetrag bestimmt;
wobei, wenn der Test zur Bewertung oder Verifikation den Positionskontrolltest umfasst: der Motor (101) für eine vorbestimmte Zeit angetrieben wird, und der Schritt des Analysierens (508) das Signal des optischen Codierers (109) decodiert, um die Motorposition zu decodieren, um zu verifizieren, ob die Motorposition und -bewegung korrekt von der Motorregelungsfirmware des eingebetteten Systems (115) gesteuert wird, und der Schritt des Analysierens (508) ferner die Motorgeschwindigkeit mithilfe von aus dem optischen Codierer (109) empfangenen Daten berechnet, um die Motorgeschwindigkeit mit der von der Motorregelungsfirmware des eingebetteten Systems (115) gewünschten Geschwindigkeit zu vergleichen; und
wobei, wenn der Test zur Bewertung oder Verifikation den Kalibriertest umfasst: der Schritt des Antreibens (504) des Motors, kontinuierlich in einer Richtung, von der Motorregelungsfirmware des eingebetteten Systems (115) durchgeführt wird, und wodurch die Bremse (103) von dem eingebetteten Simulator (110) mit voller Kraft und für lange Zeit betätigt wird, bis die aus Codiererimpulsen decodierte Motorposition gleich der erwarteten Hard-End-Position ist, und der Schritt des Analysierens (508) durchgeführt wird, indem die in dem eingebetteten System (115) gespeicherten Hard-End-Positionen gelesen werden, um die Ähnlichkeit zwischen der gelesenen Hard-End-Position mit der erwarteten Hard-End-Position zu analysieren.

2. System zur automatischen Verifikation und Bewertung einer Motorregelungsfirmware eines eingebetteten Systems, wobei das System umfasst:
mindestens einen Motor (101) ohne Last, wobei der Motor (101) eine Welle (102) umfasst;
mindestens eine Elektromagnetbremse (103) zum Anhalten des Motors (101), wobei die Elektromagnetbremse an der Welle (102) des Motors (101) angebracht ist;
mindestens einen optischen Codierer (109) zum Erkennen der Position des Motors (101), wobei eine von der Elektromagnetbremse (103) ausgehende Welle mit einer Welle des optischen Codierers (109) verbunden ist; und
mindestens einen eingebetteten Simulator (110) zum Simulieren und Empfangen von Echtzeitsignalen, wobei der eingebettete Simulator (110) konfiguriert ist, das Verfahren nach Anspruch 1 durchzuführen.

3. System nach Anspruch 2, wobei das System ein Prüfstand ist.

4. System nach Anspruch 3, wobei der Prüfstand mehrere Baugruppen des mindestens einen Motors (101), der mindestens einen Elektromagnetbremse (103), des mindestens einen optischen Codierers (109) oder eine Kombination davon, an einer einzigen Vorrichtung (100) des Prüfstands angebracht, umfasst.

5. System nach Anspruch 2 bis 4, wobei der Prüfstand eine Benutzeroberfläche umfasst, die einem Benutzer einen oder mehrere von Lesezugriff und Schreibzugriff auf Steuersignale des eingebetteten Systems, einem aktuellen Motorpositionswert, Bremsensteuersignalen oder Kombinationen davon, zum Definieren unterschiedlicher Verifikations- oder Bewertungsanforderungen für die Prüfung, bietet.

6. System nach Anspruch 2 bis 5, wobei der eingebettete Simulator umfasst:
eine Prozessorkarte (112), die bei digitalen Spannungsniveaus arbeitet;
eine Eingangs-/Ausgangskarte (114) zur Handhabung einer Vielzahl von Signalen einschließlich eines digitalen Signals, eines analogen Signals und eines impulsbreitenmodulierten Signals; und
eine Signalkonditionierungskarte zum Umsetzen eines digitalen Spannungsniveaus in einen analogen Wert und umgekehrt;
wobei die Elektromagnetbremse (103) von einem Analogausgangsstift der Eingangs-/Ausgangskarte (114), auf Basis des Eingangs von der Prozessorkarte (112), gesteuert wird.

## Revendications

1. Procédé permettant la vérification et la validation automatiques d'un micrologiciel de commande de moteur d'un système intégré (115), le système intégré étant connecté à au moins un moteur (101), ledit moteur comprenant un arbre (102) raccordé à un arbre d'un frein électromagnétique (103), ledit arbre du frein électromagnétique étant raccordé à un arbre d'un codeur optique (109), ledit procédé comprenant :
l'entraînement (504) du moteur (101) à travers le système intégré (115) selon un signal d'entrée simulé fourni au système intégré à partir d'un simulateur intégré (110) pour simuler et recevoir des signaux en temps réel, le signal d'entrée simulé étant configuré pour effectuer un essai particulier de validation ou de vérification du micrologiciel de commande de moteur, ledit essai particulier de validation ou de vérification comprenant l'un ou plusieurs d'une validation anti-pincement, d'un essai de la fonction d'arrêt progressif, d'un essai de détection de décrochage, d'un essai de détection de terminaison brutale, d'un essai de détection de position, d'un essai de détection de surcharge, d'un essai de commande de position et d'un essai d'étalonnage ;
l'application (506) d'un signal de commande de frein électromagnétique par l'intermédiaire du simulateur intégré (110) selon l'essai particulier de validation ou de vérification ;
et la réalisation de la vérification ou de la validation en analysant (508) le signal d'entrée simulé provenant du simulateur intégré (110) et les signaux provenant du codeur optique (109), lesdits signaux provenant du codeur optique identifiant la position actuelle du moteur (101) ;
si l'essai de validation ou de vérification comprend la validation anti-pincement : ladite étape d'application (506) du signal de commande de frein électromagnétique étant avec une force maximale pendant une courte durée tandis que le moteur (101) se déplace dans sa limite de course habituelle, et ladite étape d'analyse (508) vérifiant si une position de moteur décodée à partir des signaux du codeur optique augmente si la position de moteur diminuait précédemment ou diminue si la position de moteur augmentait précédemment ;
si l'essai de validation ou de vérification comprend l'essai d'une fonction d'arrêt progressif : ledit simulateur intégré (110) simulant des signaux de commande correspondant à un ou plusieurs commutateurs, les signaux de commande étant fournis au micrologiciel de commande de moteur du système intégré (115) pour déplacer le moteur (101) dans une direction en continu, et ladite étape d'analyse (508) vérifiant si le moteur (101) se déplace dans sa limite de course habituelle et est arrêté par le système intégré au niveau d'une position, ladite position décodée à partir des impulsions de codeur optique étant égale à une position d'arrêt progressif préenregistrée ;
si l'essai de validation ou de vérification comprend l'essai de détection de décrochage : ledit signal de commande de frein électromagnétique entraînant l'application du frein (103) pendant une longue durée à pleine force pendant que le moteur (101) se déplace dans sa limite de course habituelle, et ladite étape d'analyse (508) vérifiant si la position du moteur décodée à partir du codeur optique (109) ne change pas dès que les freins sont relâchés ;
si l'essai de validation ou de vérification comprend l'essai de détection de terminaison brutale : ledit signal de commande de frein électromagnétique entraînant l'application du frein (103) pendant une longue durée à pleine force pendant que le moteur (101) se déplace en dehors de sa limite de course habituelle, et ledit signal de commande de frein électromagnétique entraînant l'application du frein (103) au niveau d'une position de terminaison brutale prédéfinie, et ladite étape d'analyse (508) vérifiant si la position du moteur décodée à partir du codeur optique (109) ne change pas dès que les freins sont relâchés ;
si l'essai de validation ou de vérification comprend l'essai de détection de position : ladite étape d'entraînement (504) du moteur entraînant le moteur (101) pendant un temps prédéfini, et ladite étape d'analyse (508) comparant le changement d'un comptage de position de moteur obtenu en décodant les signaux de codeur optique avec un changement dans le comptage de position de moteur reçu du système intégré par le simulateur intégré (110) ;
si l'essai de validation ou de vérification comprend l'essai de détection de surcharge : ledit état de surcharge du moteur (101) étant créé en appliquant une entrée de tension d'alimentation réduite au frein électromagnétique (103) pendant que le moteur (101) se déplace, ledit rapport de la tension appliquée au frein (103) par rapport à la tension nominale réelle du frein déterminant une quantité de surcharge appliquée ;
si l'essai de validation ou de vérification comprend l'essai de commande de position : ledit moteur (101) étant entraîné pendant un temps prédéfini, et ladite étape d'analyse (508) décodant le signal du codeur optique (109) pour décoder la position de moteur afin de vérifier si la position et le mouvement du moteur sont correctement commandés par le micrologiciel de commande de moteur du système intégré (115), et ladite étape d'analyse (508) calculant en outre la vitesse du moteur à l'aide des données reçues du codeur optique (109) pour comparer la vitesse du moteur à la vitesse demandée par le micrologiciel de commande de moteur du système intégré (115) ; et
si l'essai de validation ou de vérification comprend l'essai d'étalonnage : ladite étape d'étalonnage (504) du moteur étant effectuée dans une direction en continu par le micrologiciel de commande de moteur du système intégré (115), et moyennant quoi le frein (103) est appliqué par le simulateur intégré (110) à pleine force et pendant une longue durée jusqu'à ce que la position du moteur décodée à partir des impulsions du codeur soit égale à la position de terminaison brutale attendue, et ladite étape d'analyse (508) étant effectuée en lisant les positions de terminaison brutale stockées dans le système intégré (115) pour analyser la similitude entre la position de terminaison brutale lue et la position de terminaison brutale attendue.

2. Système destiné à la vérification et à la validation automatiques d'un micrologiciel de commande de moteur d'un système intégré, le système comprenant :
au moins un moteur (101) sans charge, ledit moteur (101) comprenant un arbre (102) ;
au moins un frein électromagnétique (103) destiné à arrêter le moteur (101), ledit frein électromagnétique étant fixé à l'arbre (102) du moteur (101) ;
au moins un codeur optique (109) destiné à détecter la position du moteur (101), un arbre émanant du frein électromagnétique (103) étant raccordé à un arbre du codeur optique (109) ;
et au moins un simulateur intégré (110) destiné à simuler et à recevoir des signaux en temps réel, ledit simulateur intégré (110) étant configuré pour réaliser le procédé selon la revendication 1.

3. Système selon la revendication 2, ledit système étant un banc d'essai.

4. Système selon la revendication 3, ledit banc d'essai comprenant de multiples ensembles de l'au moins un moteur (101), de l'au moins un frein électromagnétique (103), de l'au moins un codeur optique (109), ou d'une combinaison de ceux-ci, fixés à un seul montage (100) du banc d'essai.

5. Système selon les revendications 2 à 4, ledit banc d'essai comprenant une interface utilisateur qui fournit à un utilisateur un ou plusieurs accès en lecture et en écriture aux signaux de commande de système intégré, à une valeur de position actuelle du moteur, à des signaux de commande de frein ou à des combinaisons de ceux-ci, pour définir les différentes exigences de vérification ou de validation des essais.

6. Système selon les revendications 2 à 5, ledit simulateur intégré comprenant :
une carte processeur (112) fonctionnant à des niveaux de tension numériques ;
une carte d'entrée/sortie (114) pour gérer une pluralité de signaux comprenant un signal numérique, un signal analogique et un signal modulé en largeur d'impulsion ; et
une carte de conditionnement de signal pour traduire un niveau de tension numérique en une valeur analogique et vice versa ;
ledit frein électromagnétique (103) étant commandé par une broche de sortie analogique de la carte d'entrée/sortie (114) sur la base de l'entrée provenant de la carte processeur (112).
